# EUROPÄISCHE PATENTSCHRIFT

(11) **EP 0 342 740 B1**
(45) Veröffentlichungstag und Bekanntmachung des Hinweises auf die Patenterteilung: **23.08.1995**
(21) Anmeldenummer: 89201186.7
(22) Anmeldetag: 11.05.1989
(51) Int. Cl.: H03L 7/22, H03L 7/10, H03D 1/22

(54) **Schaltungsanordnung zum Synchronisieren eines in der Frequenz steuerbaren Oszillators**
Circuit arrangement for the synchronisation of a frequency controlled oscillator
Montage de circuit pour la synchronisation d'un oscillateur commandé en fréquence

(30) Priorität: 17.05.1988 DE 3816696
(43) Veröffentlichungstag der Anmeldung: 23.11.1989
(73) Patentinhaber: Philips Patentverwaltung GmbH, 22335 Hamburg (DE); Philips Electronics N.V., 5621 BA Eindhoven (NL)
(72) Erfinder: Janta, Dieter, D-2000 Hamburg 61 (DE); Jansen, Winfried, D-2087 Ellerbek (DE)
(74) Vertreter: Hartmann, Heinrich, Dipl.-Ing.

(56) Entgegenhaltungen:
- EP-A- 0 051 473
- EP-A- 0 094 837
- EP-A- 0 278 079
- US-A- 3 458 823
- US-A- 4 280 104
- US-A- 4 590 602

## Beschreibung

Die Erfindung betrifft eine Schaltungsanordnung zum Synchronisieren eines in der Frequenz steuerbaren Oszillators mit der Frequenz eines in einem Eingangssignal enthaltenen Trägers, mit einer PLL-Schaltung, in der die Phasen des Eingangssignals und eines von dem steuerbaren Oszillator abgeleiteten Signals in einem Phasendiskriminator verglichen werden, dessen von der Phasenabweichung abhängiges Ausgangssignal über ein Filter einem Steuereingang des Oszillators zugeführt wird, wobei zusätzlich eine Frequenzdiskriminatoranordnung vorgesehen ist, die ein von der Differenz zwischen der Oszillatorfrequenz (fₒ) und einer in der Nähe der Trägerfrequenz liegendern stabilen Referenzfrequenz (f) abhängiges Steuersignal erzeugt, das ebenfalls dem Steuereingang des Oszillators zugeführt wird und diesen im Sinne einer Verringerung der Differenz zwischen der Referenz- und der Oszillatorfrequenz steuert, und wobei eine Blockierschaltung vorgesehen ist, die die Steuerung durch die Frequenzdiskriminatoranordnung blockiert, wenn die Oszillatorfrequenz (fₒ) in unmittelbarer Nähe der Referenzfrequenz (f) oder dichter bei der Trägerfrequenz liegt als die Referenzfrequenz.

Schaltungsanordnungen zum Synchronisieren eines steuerbaren Oszillators sind bekannt; beispielsweise enthält die als Stereodekoder für einen Rundfunkempfänger konzipierte monolithisch integrierte Schaltung TDA 1578 A eine solche Schaltung. Das in der PLL-Schaltung enthaltene Filter ist dabei so dimensioniert, daß sich ein Fangbereich von etwa 3% der Frequenz des Eingangssignals (19 KHz) ergibt. Dadurch werden einerseits Änderungen der Leerlauffrequenz des Oszillators aufgrund von Änderungen der Bauelementeeigenschaften und des Temperaturganges der Schaltung aufgefangen, und andererseits wird ein Einrasten der PLL-Schaltung auf Signalkomponenten verhindert, deren Frequenz von der Frequenz des Pilottons abweicht.

Um mit einem derart geringen Fangbereich auszukommen, ist es erforderlich, für die Bauelemente, die die Leerlauffrequenz des gesteuerten Oszillators bestimmen, enge Toleranzen vorzugeben, und zusätzlich muß ein Abgleich beispielsweise mit Hilfe eines Potentiometers durchgeführt werden.

Aus der EP-A-94 837, die diesbezüglich zumindest weitgehend der EP-A 51 473 und der US-A 4 590 602 gleichkommt, ist eine phasenverriegelte Schleife mit einer verbesserten Frequenzverstimmungs-Detektion bekannt. Ein Ausgangssignal mit variabler Frequenz soll dadurch möglichst exakt an die Frequenz und die Phase eines Eingang-Wechselsignals gekoppelt werden. Dies wird durch abwechselnden Gebrauch zweier Rückkopplungsschleifen erreicht. Ein Referenzsignal, welches eine Frequenz hat, die näherungsweise mit der Frequenz des Eingangssignals übereinstimmt, wird einer Anfangs-Rückkopplungsschleife zugeführt, in welcher es mit dem Ausgangssignal gemischt wird. Die Anfangs-Rückkopplungsschleife erzeugt ein Rückkopllungssignal zur Steuerung eines spannungsgesteuerten Oszillators, der das Ausgangssignal generiert. Ein Frequenzverstimmungsdetektor detektiert die Frequenzdifferenz zwischen dem Ausgangssignal und dem Referenzsignal. Wenn diese Frequenzdifferenz unterhalb eines bestimmten Wertes absinkt, setzt der Frequenzverstimmungsdetektor die Anfangs-Rückkopplungsschleife außer Betrieb und setzt eine Haupt-Rückkopplungsschleife in Betrieb. In der Haupt-Rückkopplungsschleife wird die Phase des Ausgangssignals mit der Phase des Eingangssignals verglichen, und das Differenzsignal steuert den spannungsgesteuerten Oszillator in der Weise, daß die Phase des Ausgangssignals diejenige des Eingangssignals nachführt. In diesem Sinne wird die Anfangsschleife, die eine hohe Bandbreite aufweist, zum Steuern des spannungsgesteuerten Oszillators in einem großen Frequenzbereich des Ausgangssignals benutzt, d.h., die Anfangsschleife hat einen breiten Fangbereich. Wenn die Frequenz des Ausgangssignals in den Fangbereich der Hauptschleife überführt ist, wird die Steuerung auf die Hauptschleife umgeschaltet. Die Hauptschleife hat eine engere Bandbreite und ermöglicht daher eine bessere Rauschunterdrückung als die Anfangsschleife.

Die im vorgenannten Stand der Technik beschriebenen Schaltungen weisen somit einen sogenannten "Monitor" und einen sogenannten "Switch" auf. Beispielsweise wird der "Monitor" in der US-A 4 590 602 durch die "lock detector means" mit dem dortigen Bezugszeichen 30 gebildet, der in der dortigen Figur 4 im einzelnen dargestellt ist und der dazu dient, festzustellen, ob die Frequenzdifferenz einen bestimmten Wert unterschritten hat (dazu dienen in Fig. 4 der US-A 4 590 602 der Quadraturdetektor 34 und ein nachgeschalteter Komperator 36). Der "Switch" wird vom "Monitor" gesteuert und soll die Steuerung durch den Frequenzdetektor (dortiges Bezugszeichen 80) unterbrechen, wenn der "Monitor" erkannt hat, daß ein gewisser Frequenzunterschied unterschritten ist.

Aufgabe der vorliegenden Erfindung ist es, eine Schaltungsanordnung der eingangs genannten Art weiter zu vereinfachen.

Diese Aufgabe wird erfindungsgemäß durch Anspruch 1 gelöst.

Bei der vorliegenden Erfindung ist somit entgegen dem Stand der Technik weder ein "Monitor" noch ein "Switch" nicht nötig. Dies liegt daran, daß die Referenzfrequenz so gewählt ist, daß sie stets oberhalb (oder stets unterhalb oder - bei zwei Referenzfrequenzen - beides) der Trägerfrequenz liegt. Außerdem ist die Nominalfrequenz des spannungsgesteuerten Oszillators so gewählt, daß sie oberhalb (oder unterhalb - bei zwei Referenzfrequenzen auch in der Mitte) liegt. Das Ausgangssignal eines jeden Frequenzdiskriminators hat dann stets ein bestimmtes Vorzeichen. Dieses Ausgangssignal läßt sich in einfacher Weise unterdrücken, z.B. durch eine geeignete gepolte Diode.

Durch die Erfindung wird somit eine gegenüber dem Stand der Technik wesentlich einfachere Schaltung erhalten, insbesondere für die Frequenzdiskriminatoranordnung. Diese muß nämlich lediglich feststellen, ob die Oszillatorfrequenz oberhalb (unterhalb) der Trägerfrequenz liegt oder nicht, und muß den Referenzoszillator lediglich in einer Richtung verstimmen.

Es ist an sich bekannt, bei Abstimmschaltungen des Istwertes von einem aus einer festen Referenzfrequenz abgeleiteten Sollwert der Zwischenfrequenz beim überschreiten eines gewissen Schwellwertes negativ den Abstimmoszillator zurückzuführen, damit eine automatische Frequenzregelung erreicht wird.

Die Erfindung benutzt die Erkenntnis, daß eine solche automatische Frequenzregelung bei einem variablen Oszillator mit im wesentlichen fester Betriebsfrequenz die Tolerenzerfordernisse an die Bauelemente, die die Leerlauffrequenz des Oszillators bestimmen, erniedrigt und daß bei Vorhandensein eines noch einem anderen Zweck dienenden Referenzoszillators dieser zur automatischen Frequenzregelung herangezogen werden kann.

Bei der Erfindung wird die Frequenz des Oszillators also zunächst der Referenzfrequenz angeglichen - und zwar auch dann, wenn die Leerlauffrequenz des Oszillators außerhalb des Fangbereichs der PLL-Schaltung liegt. Danach wird der Oszillator ausschließlich mit Hilfe des in der PLL-Schaltung enthaltenen Phasendiskriminators synchronisiert. Vergegenwärtigt man sich, daß in den meisten modernen nachrichtentechnischen Geräten, beispielsweise Rundfunkempfängern, ohnehin sehr stabile, meist durch einen Quarzoszillator erzeugte Referenzfrequenzen zur Verfügung stehen, dann ist zusätzlich lediglich eine Frequenzdiskriminatoranordnung und eine Blockierschaltung erforderlich, die sich mit relativ geringem Aufwand realisieren lassen. Mittels geeigneter Frequenzteiler kann die Referenzfrequenz dabei so dicht in die Nähe des im Eingangssignal enthaltenen Trägers gebracht werden, daß der Fangbereich der PLL-Schaltung wesentlich reduziert werden kann, so daß die bei einem größeren Fangbereich entstehenden nichtharmonischen Verzerrungen wesentlich reduziert werden und die Kanaltrennung erhalten bleibt.

Bei der Erfindung kann die Frequenzdiskriminatoranordnung relativ einfach aufgebaut sein, weil sie lediglich feststellen muß, ob die Oszillatorfrequenz oberhalb (unterhalb) der Trägerfrequenz liegt oder nicht und weil sie den Referenzoszillator lediglich in einer Richtung verstimmen muß. Auf der anderen Seite muß die Leerlauffrequenz des Oszillators dabei relativ weit von der Trägerfrequenz ab liegen, auf der der Oszillator im synchronisierten Zustand schwingt, damit die Oszillatorfrequenz unabhängig von Temperaturschwankungen und Fertigungsstreuungen stets oberhalb oder unterhalb der Trägerfrequenz liegt. Der Oszillator wird dabei also in der Regel relativ stark verstimmt, was Vorkehrungen erfordert, damit die Phasendifferenz zwischen der Oszillatorschwingung und der Trägerschwingung klein bleibt.

Eine andere Ausgestaltung der Erfindung, bei der vorausgesetzt wird, daß ein Oszillator mit stabilisierter Frequenz vorhanden ist, sieht vor, daß zwei Frequenzteiler vorgesehen sind, deren Frequenzteilerfaktoren so gewählt sind, daß sich eine erste Referenzfequenz ergibt, die unterhalb der Trägerfrequenz liegt, und eine zweite Referenzfrequenz, die oberhalb der Trägerfrequenz liegt,und daß die Blockierschaltung so geschaltet ist, daß die Steuerung des steuerbaren Oszillators durch die Frequenzdiskriminatoranordnung blockiert wird, wenn die erste Oszillatorfrequenz zwischen der ersten und der zweiten Referenzfrequenz liegt. Mittels der beiden Frequenzteiler werden hierbei also die beiden Referenzfrequenzen aus der Frequenz des stabilisierten Oszillators erzeugt. Bei dieser Ausführung verdoppelt sich zwar der Aufwand für die Frequenzdiskriminatoranordnung und für die Blockierschaltung, doch kann dafür der gesteuerte Oszillator so dimensioniert sein, daß seine Leerlauffrequenz der Trägerfrequenz entspricht. Je nach den Fertigungsstreuungen bzw. Temperaturschwankungen, denen der jeweilige Oszillator ausgesetzt war bzw. ist, kann seine Leerlauffrequenz dabei zwischen den beiden Referenzfrequenzen, unterhalb der ersten Referenzfrequenz oder oberhalb der zweiten Refe renzfrequenz liegen, und in jedem Fall ist ein "Einfangen" des Oszillators gewährleistet.

Die Frequenzdiskriminatoranordnung kann in unterschiedlicher Weise aufgebaut sein. Eine digitale Ausführungsform eines solchen Frequenzdiskriminators könnte einen mit einem definierten Zählerstand geladenen Zähler enthalten, der innerhalb einer Periode der Schwingung des gesteuerten Oszillators durch die Schwingungen eines stabilisierten Oszillators mit wesentlich höher Frequenz heruntergezählt wird, wobei der gesteuerte Oszillator solange nachgestimmt wird, bis der Zähler innerhalb einer Periode jeweils auf den Wert 0 heruntergezählt ist. Dadurch würde der Oszillator so weit verstimmt, bis seine Frequenz innerhalb von zwei Referenzfrequenzen liegen würde, die von der Frequenz des stabilisierten Oszillators und dem Zählerstand des Zählers abhängt. Diese Werte werden zweckmäßigerweise so gewählt, daß die sich ergebenden Referenzfrequenzen beiderseits der Trägerfrequenz liegen.

Die vorstehend angegebene digitale Ausführungsform, die schon die Blockierschaltung mitbeinhalten würde, ist zumindest beim derzeitigen Stand der Halbleitertechnik noch relativ aufwendig. Eine bevorzugte Weiterbildung der Erfindung sieht daher vor, daß die Frequenzdiskriminatorschaltung wenigstens einen frequenzempfindlichen Phasendiskriminator enthält. Derartige frequenzempfindliche Phasendedektoren sind an sich bekannt und in dem Buch "Halbleitertechnik" von Tietze/Schenk (4.Auflage, Seite 691 ff.) beschrieben. Außerdem sind derartige Phasendektoren Bestandteil verschiedener integrierter Schaltungen, zum Beispiel der integrierten Schaltung HEF 4046 B.

Wie bereits erwähnt, gibt es Frequenzdiskriminatoranordnungen, die eine Blockierung beinhalten, wenn die Frequenz des gesteuerten Oszillators eine bestimmten Wert oder einen bestimmten Frequenzbereich erreicht hat. Bei diesen Schaltungen ist eine zusätzliche Blockierschaltung nicht mehr erforderlich. Andere Frequenzsdiskriminatorschaltungen beinhalten diese Möglichkeit jedoch nicht, und eine hierfür vorgesehene Ausgestaltung der Erfindung sieht vor, daß die Frequenzdiskriminatoranordnung mindestens einen Frequenzdiskriminator mit je einem Eingang für die aus dem Oszillatorsignal abgeleitete Frequenz und für die Referenzfrequenz aufweist, daß der Frequenzdiskriminator einen Strom einer ersten Polarität liefert, wenn die Frequenz an dem einen Eingang größer ist als am anderen Eingang und einen Strom einer zweiten Polarität, wenn die Frequenz an dem Eingang kleiner ist als am anderen Eingang und daß der Ausgang des Frequenzdiskriminators über eine Diode mit dem Steuereingang des steuerbaren Oszillators verbunden ist.

Die Erfindung soll nachstehend an Hand der Zeichnung näher erläutert werden. Es zeigen:
Figur 1 das Prinzipschaltbild einer erfindungsgemäßen Schaltung,
Figur 2 das Detailschaltbild einer mit Hilfe von Integrierten Schaltungen aufgebauten ersten Ausführungsform
Figur 3 den zeitlichen Verlauf verschiendener Signale bei einem in Verbindung mit der Erfindung einsetztbaren Frequenzdiskriminator und
Figur 4 eine zweite Ausführungsform.
Fig. 5 eine dritte Ausführungsform.

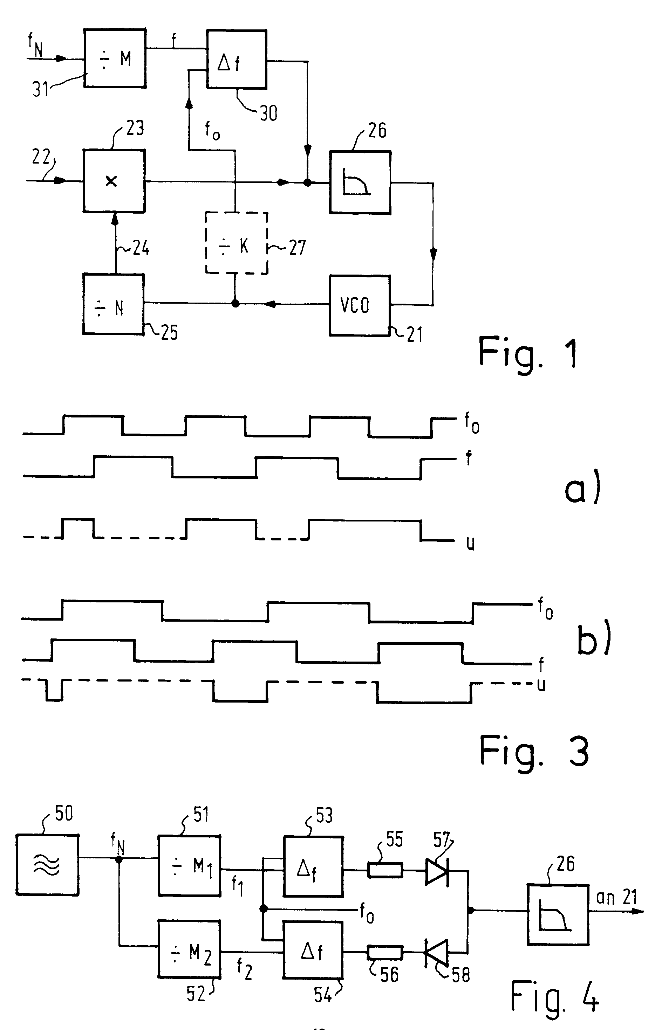

In Figur 1 ist eine Schaltung dargestellt, die der Synchronisation eines in der Frequenz steuerbaren Oszillators 21 mit einem in dem Signaleingang 22 enthaltenen Pilotton (19 kHz) dient und in einem Stereodekoder verwendet werden kann, um die auf einen unterdrückten Hilfsträger (38 kHz) modulierten sogenannten Differenzsignale zu demodulieren. Der Eingang 22 ist zugleich ein Eingang eines Phasendiskriminators 23, der einen weiteren Eingang 24 aufweist. Der Eingang 24 ist mit dem Ausgang eines Frequenzteilers 25 verbunden, in dem die Frequenz des am Eingang dieses Frequenzteilers anliegenden Signals, nämlich des Ausgangssignals des steuerbaren Oszillators 21, durch den Faktor N geteilt wird. Das Ausgangssignal des Phasendiskriminators 23, der eine analoge Multiplizierschaltung sein kann, wird über einen Tiefpaß 26 dem Steuereingang des in der Frequenz steuerbaren Oszillators 21 zugeführt. Dessen Frequenz ändert sich dabei so lange, bis die Schwingungen an den Eingängen 21 und 24 die gleiche Frequenz und praktisch die gleiche Phase haben. Insoweit als bisher beschrieben handelt es sich um eine in vielen Varianten bekannte PLL-Schaltung.

Zusätzlich ist eine Frequenzdiskriminatorschaltung 30 vorgesehen, die die vom Oszillator 21 erzeugte und gegebenenfalls mit Hilfe eines Frequenzteilers 27 heruntergeteilte Frequenz fₒ mit einer Frequenz f vergleicht, die aus einer stabilen Frequenz f_{N} mit Hilfe eines Frequenzteilers 31 erzeugt wird. Die Frequenz f_{N} kann mittels eines nicht näher dargestellten frequenzstabilen Oszillators, beispielsweise eines Quarzoszillators, erzeugt werden. Der Frequenzdiskriminator 30 liefert an seinem Ausgang, der mit dem Ausgang des Phasendiskriminators 23 verbunden ist, ein Signal, das von der Frequenzdifferenz abhängt. Die Frequenz f_{N} und gegebenenfalls der Frequenzsteilerfaktor des Frequenzsteilers 31 sind so gewählt, daß die resultierende Frequenz nur wenig von derjenigen Frequenz fₒ abweicht, die der Oszillator 21 liefert, wenn er auf den im Eingangssignal enthaltenen Pilotton synchronisiert ist. Der Ausgang des Frequenzdiskriminators 30, der mit dem Ausgang des Phasendiskriminators 23 verbunden ist liefert ein Signal, das von der Differenz der Frequenzen fₒ abhängt. Dieses Signal steuert über den Tiefpaß 26 den Steuereingang des steuerbaren Oszillators 21 derart, daß die Differenz zwischen den Frequenzen fₒ abnimmt. Wenn die Frequenz fₒ der Frequenz f entspricht oder in einem definierten Bereich um diese Frequenz herum liegt, wird der Frequenzdiskriminator unwirksam. Der Oszillator 21 liefert dann eine Frequenz, die schon recht dicht bei der Frequenz des Pilottons liegt. Obwohl die Leerlauffrequenz des gesteuerten Oszillators relativ weit von der gewünschten Frequenz abliegen kann, kann aus diesem Grunde ein Tiefpaß 26 mit relativ niedrigerer Grenzfrequenz verwendet werden, was einerseits einen kleinen Fangbereich, andererseits aber auch wenig Phasenstörungen zur Folge hat.

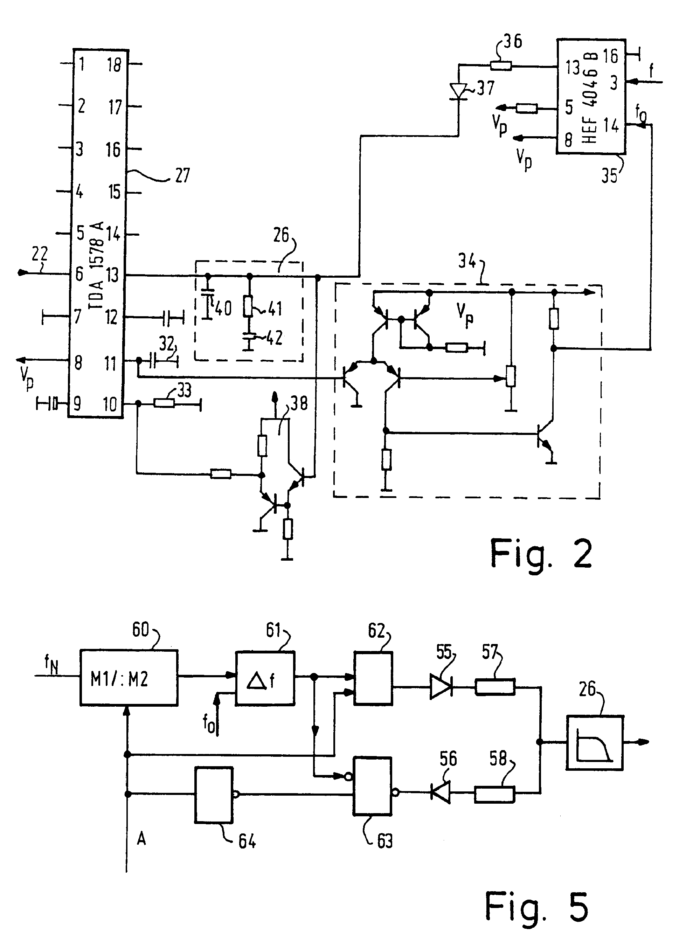

In Figur 2 ist ein mit Hilfe von integrierten Schaltungen realisiertes Ausführungsbeispiel für einen Stereodekoder dargestellt. Die PLL-Schaltung ist dabei überwiegend in der integrierten Schaltung TDA 1578 A enthalten, deren äußere Beschaltung nur im Hinblick auf ihre pins 6..13 aus der Zeichnung ersichtlich ist. Die Beschaltung der pins 1 bis 5 und 14 bis 18 kann der in den Datenbüchern empfohlenen Beschaltung entsprechen. Das Stereomultiplexsignal, das unter anderem auch den Pilotton enthält, wird an pin 6 der Schaltung zugeführt, deren Versorgungsspannung an die Klemmen 7 und 8 angeschlossen wird. Der in der integrierten Schaltung enthaltene Oszillator umfaßt eine Stromquellenanordnung, die einen Kondensator 32 periodisch auf- und entlädt, wobei der Übergang zwischen Aufladung und Entladung erfolgt, wenn die Spannung am Kondensator einen oberen bzw. einen unteren Wert erreicht hat. Die Größe des von der Stromquellenanordnung gelieferten Aufund Entladestroms wird durch den Gleichstrom bestimmt, der über pin 10 fließt und damit durch den an diesem pin angeschlossenen Widerstand 33. Somit kann die Frequenz des Oszillators durch die an die pins 10 und 11 angeschlossene RC-Kombination vorgegeben werden. Obwohl die Oszillatorfrequenz 76 kHz beträgt, wenn er mit der Frequenz des Pilottons (19kHz) synchronisiert ist, wurde die RC-Kombination 32,33 so bemessen, daß sich für ein Normalexemplar der Schaltung TDA 1578 A bei der üblichen Umgebungstemperatur und exakt eingehaltenen Werten eine Leerlauffrequenz von 85 kHz ergibt. Dieser Bemessung liegt die Annahme zugrunde, daß auch bei ungünstigem Zusammentreffen von Fertigungsstreuungen, Bauelementetoleranzen und Temperaturgängen die an sich erwünschte Frequenz von 76 kHz die untere Grenze des Streubereiches der Leerlauffrequenz des Oszillators darstellt.

Die Spannung am Kondensator 32, die einen dreieckförmigen Verlauf hat, wird über den Verstärker 34 in eine symetrische Rechteckspannung umgeformt und einer integrierten Schaltung 35 vom Typ HEF 4046 B zugeführt, die einen als Frequenzdiskriminator wirksamen, mit seinen Eingängen an die pins 3 und 14 und mit seinem Ausgang an pin 13 angeschlossenen frequenzempfindlichen Phasendetektor enthält. Die Oszillatorfrequenz fₒ wird an pin 14 zugeführt, während die Referenzfrequenz f, die bei 77 kHz liegt, an pin 3 zugeführt wird. Die Frequenz f ist dabei so gewählt, daß sie auf der gleichen Seite in Bezug auf die Sollfrequenz liegt wie die Leerlauffrequenz des Oszillators - in dem angenommenen Beispiel also oberhalb - und in der Regel wesentlich dichter bei der Sollfrequenz als die Leerlauffrequenz. Ein geeigneter Wert für die Frequenz f ist beispielsweise 77 kHz.

Der frequenzempfindliche Phasendetektor enthält an seinem Ausgang zwei schaltbare Stromquellen, die Ströme entgegengesetzter Polarität liefern. Wenn die Oszillatorfrequenz fₒ größer ist als die Referenzfrequenz f, wie in Figur 3a dargestellt, dann wird die eine Stromquelle durch die positiven Flanken des Oszillatorsignal ein- und durch die positive Flanke des Referenzsignals ausgeschaltet, wobei das Potenzial u am Ausgang (pin 13) des Phasendetektors auf einen positiven Wert springt; in dem Zeitraum zwischen der positiven Flanke des Referenzsignals und der positiven Flanke des Oszillatorsignals sind beide Stromquellen ausgeschaltet.

Wenn die Oszillatorfrequenz fₒ niedriger ist als die Referenzfrequenz (vergl. Figur 3b), wird die andere Stromquelle durch die positiven Flanken des Referenzsignals ein- und durch die positiven Flanken des Oszillatorsignals ausgeschaltet, wobei wiederum in den Pausen beide Stromquellen ausgeschaltet sind. Der frequenzempfindliche Phasendetektor 35 liefert also anseinem Ausgang einen pulsiernden Gleichstrom, dessen Polarität positiv ist, wenn fₒ größer ist als f, und negativ, wenn fₒ kleiner ist als f. Der Ausgang ist über einen Widerstand 36 von 330 kOhm und eine Diode, die nur die positiven Stromimpulse durchläßt, mit dem Eingang eines Impedanzwandlers 38 verbunden, der einen hochohmigen Eingang und einen niederohmigen Ausgang hat, der über einen Widerstand 39 von ebenfalls 330 kOhm mit dem pin 10 der Schaltung 27 verbunden ist, der den Steuereingang des darin enthaltenen steuerbaren Oszillators bildet. Der über pin 10 zum externen Widerstand 33 fließende Strom vermindert sich entsprechend dem von dem Impedanzwandler 38 gelieferten Strom, so daß auch die Oszillatorfrequenz abnimmt. Dieser Regelvorgang dauert solange an, bis die Oszillatorfrequenz fₒ der Referenzfrequenz f entspricht. Danach ist der Phasendetektor wegen der Diode 37 unwirksam.

Wenn das Eingangssignal am Eingang 22 (= pin 6) einen Pilotton enthält, dann liefert der in der Schaltung 27 enthaltene Phasendiskriminator am pin 13 ein Regelsignal, das über den Tiefpaß 26 dem Impedanzwandler zugeführt wird und die Oszillatorfrequenz weiterhin erniedrigt, bis eine Frequenz von 76 kHz entsprechend dem Vierfachen der Pilottonfrequenz erreicht ist; dann ist die PLL-Schaltung eingerastet.

Das Tiefpaßfilter 26 filtert nicht nur das Ausgangssignal des in der Schaltung 27 enthaltenen Phasendiskriminators sondern auch das Ausgangssignal des frequenzempfindlichen Phasendetektors 35. Es enthält zwei parallel geschaltete Querzweige, von denen der eine aus einem Kondensator 40 von 220 nF und der andere aus der Serienschaltung eines Widerstandes 41 von 22 kOhm und eines Kondensators 42 von 150 nF besteht. Die Grenzfrequenz dieses Tiefpaßes ist somit wesentlich niedriger als in dem Datenbuch für die Integrierte Schaltung TDR 1578 A empfohlen, weil der Fangbereich wegen des vorgegebenen geringem Abstandes zwischen der Referenzfrequenz f und der gewünschten Frequenz relativ klein sein kann.

Zwischen der Leerlauffrequenz des Oszillators (85 kHz, bei ungünstigem Zusammentreffen von Temperaturschwankungen und Fertigungsstreuungen aber auch wesentlich mehr) und der Frequenz, mit der der Oszillator synchronisiert werden soll (76 kHz), kann ein relativ großer Unterschied bestehen. Daraus ergibt sich im gerastetem Zustand der PLL-Schaltung eine relativ große Phasenverschiebung zwischen dem am Eingang 22 vorhandenen Pilotsignal und dem aus dem 76 kHz-Ausgangssignal des Oszillators durch Frequenzteilung abgeleiteten 19 kHz-Signal, der zu einer Verschlechterung der Kanaltrennung des Stereodekoders führen kann, der mit dem 19 kHz Signal gespeist wird. Dieser Phasenfehler läßt sich aber durch eine Vergrößerung der Schleifenverstärkung in der PLL-Schaltung verringern. Diesem Zweck dient der Impedanzwandler 38.

Figur 4 zeigt eine Ausführungsform, bei der die Komponenten 30 und 31 der Figur 1 durch die Komponenten 50..58 ersetzt sind. Mit 50 ist dabei ein Oszillator mit stabiler Frequenz bezeichnet, beispielsweise ein Quarzoszillator. Das Oszillatorsignal mit der Frequenz fN wird den Eingängen zweier Frequenzteiler 51 und 52 zugeführt. Die Frequenzteiler 51 und 52 haben unterschiedliche Frequenzteilerfaktoren, die so gewählt sind, daß sich eine erste Referenzfrequenz f₁ ergibt, die unterhalb der Trägerfrequenz liegt, und (am Ausgang des Frequenzteilers 52) eine zweite Referenzfrequenz f₂, die dicht oberhalb der Referenzfrequenz liegt. Wenn beispielsweise die Oszillatorfrequenz im synchronisierten Zustand 76 kHz betragen soll und wenn die Frequenz f_{N} des Oszillators 50 4 MHz beträgt, dann sollte der Frequenzteiler 51 einen Frequenzteilerfaktor von 53 haben und der Frequenzteiler 52 einen Frequenzteilerfaktor von 52. Darauß würden Referenzfrequenzen f₁ gleich 75,5 kHz und f₂ gleich 76,9 kHz resultieren. Die beiden Referenzfrequenzen bilden also ein Frequenzfenster, innerhalb dessen die gewünschte Oszillatorfrequenz liegt.

Die beiden Frequenzteiler sind mit je einem der frequenzempfindlichen Phasendetektoren 53 und 54 gekoppelt, die den gleichen Aufbau haben können wie der an Hand von Figur 2 erläuterte Frequenzdetektor 35. Die Referenzfrequenzen f₁ bzw. f₂ werden jeweils dem ersten Eingang der Detektoren 53 bzw. 54 zugeführt, an derem zweiten Eingang jeweils die Oszillatorfrequenz fₒ anliegt. Der Ausgang des Phasendetektors 53 ist über die Serienschaltung eines Widerstandes 55 und einer Diode 75 mit dem Tiefpaß 26 der im übrigen nicht näher dargestellten PLL-Schaltung verbunden. Der Ausgang des Phasendetektors 54 ist mit dem Tiefpaß 26 ebenfalls über die Serienschaltung eines Widerstandes 56 und einer Diode 58 verbunden, jedoch ist die Diode 58 (vom Tiefpaß 26 aus gesehen) in entgegengesetzter Richtung gepolt wie die Diode 57.

Die Schaltung gemäß Figur 4 arbeitet folgendermaßen, wenn die Leerlauffrequenz fₒ des Oszillators unterhalb der Referenzfrequenz f₁ liegt: Die beiden Detektoren 53 und 54 liefern Stromimpulse mit positiver Polarität, wobei nur die vom Detektor 53 gelieferten Stromimpulse zum Eingang des Tiefpaßes 26 gelangen können, weil die positiven Stromimpulse des Detektors 54 durch die Diode 58 unterdrückt werden. Daraus resultiert am Ausgang des Filters eine Spannung, die den in Figur 4 nicht dargestellten, gesteuerten Oszillator 21 zu höheren Frequenzen hin verstimmt. Wenn die Oszillatorfrequenz fₒ den Wert der Referenzfrequenz f₁ erreicht bzw. überschritten hat, kehrt sich die Polarität der von dem Detektor 53 gelieferten Stromimpulse um, jedoch werden diese wegen der Diode 57 nicht wirksam. In diesem Zustand, in dem die Ausgangssignale beider Detektoren 53 und 54 durch die nachgeschalteten Dioden 57 und 58 blockiert werden, liegt die Oszillatorfrequenz zwischen den Referenzfrequenzen f₁ und f₂, und der gesteuerte Oszillator wird danach auschließlich mittels der in Figur 4 nicht näher dargestellten PLL-Schaltung auf den gewünschten Wert gebracht.

Wenn die Frequenz fₒ des Oszillators anfangs oberhalb der Referenzfrequenz f₂ liegt, liefern beide Detektoren 53 und 54 Stromimpulse mit negativer Polarität; jedoch werden die Stromimpulse des Detektors 53 durch die Diode 57 unterdrückt. Die negativen Stromimpulse bewirken über den Tiefpaß 26, daß der gesteuerte Oszillator 21 in der Frequenz nach niedrigeren Frequenzen hin verstimmt wird ,bis er den Wert f₂ erreicht hat. Dann kehrt sich die Polarität der vom Detektor 54 gelieferten Signale um; doch werden diese Signale durch die Diode 58 nunmehr unterdrückt. Die Phasendetektoren 53 und 54 sind dann also beide unwirksam, und die weitere Verstimmung des gesteuerten Oszillators erfolgt dann durch dei PLL-Schaltung.

Wenn die Leerlauffrequenz fₒ von vornherein zwischen den beiden Werten f₁ und f₂ liegt, erfolgt die Nachstimmung des Oszillators ausschließlich mit Hilfe der PLL-Schaltung.

Der Vorteil der Schaltung gemäß Figur 4 gegenüber der Schaltung nach Figur 2 besteht darin, daß der Nennwert der Leerlauffrequenz des Oszillators mit der Frequenz identisch sein kann, die der Oszillator im synchronisierten Zustand einnimmt. Trotz Fertigungsstreuung und Temperaturschwankungen ist der Unterschied zwischen der Frequenz des Oszillators im synchronisierten Zustand und der Leerlauffrequenz in der Regel kleiner als bei einer Schaltung nach Figur 2, so daß sich kleinere Phasenfehler ergeben. Dafür ist der Aufwand für Frequenzteiler, Phasendetektor und Blockierschaltung aber doppelt so hoch wie bei der Schaltung nach Figur 2.

Eine Schaltung, die die gleichen Vorteile aufweist wie die Schaltung nach Fig. 2 und die weniger aufwendig ist, ist in Fig. 5 dargestellt. Die Anschlüsse der Serienschaltung 55, 56, 58 sind dabei über je ein UND-Gatter 62 bzw. 63 mit dem Ausgang eines frequenzempfindlichen Phasendetektors 61 verbunden, der den gleichen Aufbau haben kann wie der Detektor 35 in Fig. 2; der Eingang dieses Detektors ist mit dem Ausgang eines umschaltbaren Frequenzteilers 60 verbunden, dessen Eingang die stabile Frequenz f_{N} zugeführt wird. Der Ausgang des UND-Glieder 63 ist invertiert und ebenso sein mit dem Ausgang des Detektors 61 verbundener Eingang. Impulse mit positiver Polarität können also über die Widerstands-Diodenstrecke 55, 57 das Tiefpaßfilter 26 erreichen und solche mit negativer Polarität über die Dioden-Widerstandsstrecke 56,58 - wenn am zweiten Eingang der vorgeschalteten UND-Schaltung 62 und 63 ein geeignetes Signal anliest. Dieses Signal A, das den Frequenzteilerfaktor der Schaltung 60 bestimmt, wird dem zweiten Eingang der UND-Schaltung 62 direkt und dem zweiten Eingang der UND-Schaltung 63 über ein Invertierglied 64 zugeführt.

Die Schaltung arbeitet folgendermaßen: Für A = 1 wird der Frequenzteilerfaktor M₁ eingeschaltet, so daß die Ausgangsfrequenz des Frequenzteilers 60 f₁ ist. Wenn die Oszillatorfrequenz niedriger ist als die Frequenz f₁, haben die Ausgangsimpulse des Detektors 61 eine positive Polarität und erreichen über die dann geöffnete UND-Schaltung 62, die Diode 55 und den Widerstand 57 das Filter 26. Dadurch wird die Oszillatorfrequenz solange angehoben, bis die Frequenz fₒ die Frequenz f₁ überschreitet. Die dann auftretenden negativen Impulse werden von der Diode 55 blockiert und können die Diode 56 nicht erreichen, weil das UND-Gatter 63 dann gesperrt ist.

Wenn das Signal A den Wert "0" hat, hat das Ausgangssignal der Frequenzteilerschaltung 60 den Wertf₂. Falls die Oszillatorfrequenz fₒ oberhalb der Frequenz f₂ liegt, liefert der Detektor 61 Impulse mit negativer Polarität, die über das dann geöffnete UND-Gatter 63 und die Diode 56 und den Widerstand 58 den Tiefpaß 26 erreichen können, dessen Ausgangssignal den nicht näher dargestellten, in der Spannung steuerbaren Oszillator 21 (Fig. 1) solange verstimmt, bis die Oszillatorfrequenz fₒ den Wert f₂ unterschreitet. Die Ausgangsimpulse erhalten dann eine positive Polarität, die von der Diode 56 unterdrückt würde und die die Diode 55 nicht erreichen kann, weil das UND-Gatter 62 gesperrt ist.

Befindet sich also die Oszillatorfrequenz fₒ unterhalb der niedrigeren Referenzfrequenz f₁ oder oberhalb der höheren Referenzfrequenz f₂, wird der Oszillator solange verstimmt, bis die Oszillatorfrequenz sich im Bereich zwischen f₁ und f₂ befindet. Danach wird die Schaltung unwirksam.

Wenn bei dem Signal A = 0 die Frequenz f₀ niedriger liegt als f₁ oder wenn bei dem Signal A = "1" die f₀ höher liegt als f₂, ist die Schaltung ebenfalls nicht wirksam. Um in diesem Fall die gewünschte Verstimmung des Oszillators zu erreichen, muß das Signal A invertiert werden. Dies kann dadurch erfolgen, daß das Signal periodisch mit genügend großer Periodendauer invertiert wird. Es ist aber auch möglich, eine in Fig. 5 nicht näher dargestellte Logikschaltung vorzusehen, die immer dann, wenn am Verbindungspunkt der Widerstände 57 und 58 keine (positiven oder negativen) Impulse auftreten, die Polarität des Signals A invertiert.

Vorstehend wurde der Einsatz der Erfindung an Hand eines PLL-Stereodekoders beschrieben, jedoch ist die Erfindung darauf nicht beschränkt. Sie kann ebenso in Dekodierschaltungen für den Verkehrsfunk oder das Radiodatensystem eingesetzt werden. Allgemein ist ein Einsatz bei PLL-Demodulatorschaltungen möglich, bei denen der Oszillator mit einer bekannten Trägerfrequenz synchronisiert werden soll.

## Patentansprüche

1. Schaltungsanordnung zum Synchronisieren eines in der Frequenz steuerbaren Oszillators mit der Frequenz eines in einem Eingangssignal enthaltenen Trägers, mit einer PLL-Schaltung, in der die Phasen des Eingangssignals und eines von dem steuerbaren Oszillator abgeleiteten Signals in einem Phasendiskriminator verglichen werden, dessen von der Phasenabweichung abhängiges Ausgangssignal über ein Filter einem Steuereingang des Oszillators zugeführt wird, wobei zusätzlich eine Frequenzdiskriminatoranordnung vorgesehen ist, die ein von der Differenz zwischen der Oszillatorfrequenz (fₒ) und einer in der Nähe der Trägerfrequenz liegenden stabilen Referenzfrequenz (f) abhängiges Steuersignal erzeugt, das ebenfalls dem Steuereingang des Oszillators zugeführt wird und diesen im Sinne einer Verringerung der Differenz zwischen der Referenz- und der Oszillatorfrequenz steuert, und wobei eine Blockierschaltung (57,58) vorgesehen ist, die die Steuerung durch die Frequenzdiskriminatoranordnung blockiert, wenn die Oszillatorfrequenz (fₒ) in unmittelbarer Nähe der Referenzfrequenz (f) oder dichter bei der Trägerfrequenz liegt als die Referenzfrequenz,
dadurch gekennzeichnet,
daß die sich ohne Zuführen eines Steuersignals am Steuereingang des Oszillators als Oszillatorfrequenz (fₒ) einstellende Leerlauffrequenz des Oszillators so gewählt ist, daß sie unabhängig von Schwankungen der Fertigungs- und Betriebsparameter in einem ersten Fall oberhalb bzw. in einem zweiten Fall unterhalb der Tragerfrequenz liegt, daß die Referenzfrequenz (f) so gewählt ist, daß sie ebenfalls im ersten Fall oberhalb bzw. im zweiten Fall unterhalb der Trägerfrequenz und zwischen der Leerlauffrequenz und der Trägerfrequenz liegt, und daß die Blockierschaltung (57,58) die Steuerung des Oszillators durch die Frequenzdiskriminatoranordnung blockiert, wenn die Oszillatorfrequenz (fₒ) im ersten Fall niedriger bzw. im zweiten Fall höher geworden ist als die Referenzfrequenz (f).

2. Schaltungsanordnung nach Anspruch 1,
dadurch gekennzeichnet,
daß die Referenzfrequenz mittels eines Referenzoszillators erzeugt wird.

3. Schaltungsanordnung nach Anspruch 2,
dadurch gekennzeichnet,
daß die Frequenz des Referenzoszillators höher ist als die Trägerfrequenz und daß die Referenzfrequenz aus der Frequenz des Referenzoszillators mittels wenigstens eines Frequenzteilers (31,51,53) abgeleitet wird.

4. Schaltungsanordnung nach Anspruch 3,
dadurch gekennzeichnet,
daß zwei Frequenzteiler (51,52) vorgesehen sind, deren Frequenzteilerfaktoren so gewählt sind, daß sich eine erste Referenzfrequenz (f₁) ergibt, die unterhalb der Trägerfrequenz liegt, und eine zweite Referenzfrequenz (f₂), die oberhalb der Trägerfrequenz liegt, und daß die Blockierschaltung (57,58) so geschaltet ist, daß die Steuerung des steuerbaren Oszillators durch die Frequenzdiskriminatoranordnung (53,54) blockiert wird, wenn die Oszillatorfrequenz (fₒ) zwischen der ersten und der zweiten Referenzfrequenz (f₁,f₂) liegt.

5. Schaltungsanordnung nach Anspruch 4,
dadurch gekennzeichnet,
daß die Frequenzdiskriminatoranordnung zwei gleichartige aufgebaute Frequenzdiskriminatoren (53,54) mit je zwei Eingängen für die zu vergleichenden Frequenzen aufweist, daß das Oszillatorsignal dem ersten Eingang der Frequenzdiskriminatoren (53 und 54) zugeführt wird, daß die Referenzfrequenzen (f₁ und f₂) dem zweiten Eingang jeweils eines der beiden Detektoren zugeführt werden, und daß die Blockierschaltung (57,58) den einen Frequenzdiskriminator (53) bei oberhalb der ersten Referenzfrequenz (f₁) liegender Oszillatorfrequenz (fₒ)
und den anderen Frequenzdiskriminator (54) bei unterhalb der zweiten Referenzfrequenz liegender Oszillatorfrequenz blockiert.

6. Schaltungsanordnung nach einem der vorhergehenden Ansprüche,
dadurch gekennzeichnet,
daß die Frequenzdiskriminatorschaltung wenigstens einen frequenzempfinglichen Phasendiskriminator ernthält.

7. Schaltungsanordnung nach einem der vorhergehenden Ansprüche,
dadurch gekennzeichnet,
daß die Frequenzdiskriminatoranordnung mindestens einen Frequenzdiskriminator (35,53,54) mit je einem Eingang für die aus dem Oszillatorsignal abgeleitete Frequenz (fₒ) und für die Referenzfrequenz (f) aufweist, daß der Frequenzdiskriminator einen Strom einer ersten Polarität liefert, wenn die Frequenz an dem einen Eingang größer ist als am anderen Eingang, und einen Strom einer zweiten Polarität, wenn die Frequenz an dem Eingang kleiner ist als am anderen Eingang, und daß der Ausgang des Frequenzdiskriminators über wenigstens eine Diode (36,57,58) mit einem Steuereingang des steuerbaren Oszillators verbunden ist.

8. Schaltungsanordnung nach Anspruch 7,
dadurch gekennzeichnet,
daß eine obere (f₁) und eine untere Referenzfrequenz (f₂) aus einer stabilisierten Frequenz (f_{N}) mittels eines Frequenzteilers (60) mit umschaltbarem Frequenzteilerfaktor abgeleitet wird, wobei die untere Referenzfrequenz niedriger und die obere Referenzfrequenz höher liegt als die Trägerfrequenz (fₒ).

9. Schaltungsanordnung nach Anspruch 1, wobei dem Steuereingang des steuerbaren Oszillators zur Beeinflußung der Frequenz ein Steuerstrom zugeführt wird und der phasendiskriminator einen hohen Ausgangswiderstand aufweist,
dadurch gekennzeichnet,
daß das Ausgangssignal des Phasendiskriminators (27) und der Frequenzdiskriminatoranordnung (35) dem Steuereingang über einen Verstärker (38) mit hochohmigem Eingang und niederohmigem Ausgang zugeführt wird.

10. Schaltungsanordnung nach einem der vorhergehenden Ansprüche,
gekennzeichnet durch,
ihre Verwendung in einem Rundfunkempfänger.

11. Schaltungsanordnung nach Anspruch 9,
gekennzeichnet durch
ihre Verwendung in einem Stereodekoder.

## Claims

1. A circuit arrangement for synchronizing a frequency-controllable oscillator with the frequency of a carrier contained in an input signal, said circuit arrangement comprising a PLL circuit in which the phase of the input signal and that of a signal derived from the controllable oscillator are compared in a phase discriminator whose output signal, which is dependent on the phase difference, is applied to a control input of the oscillator via a filter, a frequency discriminator arrangement being provided in addition, which frequency discriminator arrangement generates a control signal which is dependent on the difference between the oscillator frequency (fₒ) and a stable reference frequency (f) in the proximity of the carrier frequency, said control signal being also applied to the control input of the oscillator and controlling said oscillator so as to reduce the difference between the reference frequency and the oscillator frequency, and a blocking circuit (57, 58) being provided, which blocking circuit blocks control by the frequency discriminator arrangement when the oscillator frequency (fₒ) is proximate to the reference frequency (f) or is closer to the carrier frequency than the reference frequency,
characterised in that
the free-running frequency of the oscillator, which is the oscillator frequency (fₒ) in the absence of a control signal at the control input of the oscillator, is selected in such a manner that in a first case it is above and in a second case it is below the carrier frequency independently of variations in manufacturing and operation parameters, in that the reference frequency (f) is selected in such a manner that in the first case it is also above and in the second case it is below the carrier frequency and between the free-running frequency and the carrier frequency, and in that the blocking circuit (57, 58) blocks the control of the oscillator by the frequency discriminator arrangement when the oscillator frequency (fₒ) in the first case has become lower and in the second case has become higher than the reference frequency (f).

2. A circuit arrangement as claimed in Claim 1,
characterised in that
the reference frequency is generated by means of a reference oscillator.

3. A circuit arrangement as claimed in Claim 2,
characterised in that
the frequency of the reference oscillator is higher than the carrier frequency and in that the reference frequency is derived from the frequency of the reference oscillator by means of at least one frequency divider (31, 51, 53).

4. A circuit arrangement as claimed in Claim 3,
characterised in that
two frequency dividers (51, 52) are provided whose frequency division factors are selected so as to obtain a first reference frequency (f₁) below the carrier frequency and a second reference frequency (f₂) above the carrier frequency, and in that the blocking circuit (57, 58) is arranged in such a manner that the control of the controllable oscillator by the frequency discriminator arrangement (53, 54) is blocked when the oscillator frequency (fₒ) is between the first and the second reference frequency (f₁, f₂).

5. A circuit arrangement as claimed in Claim 4,
characterised in that
the frequency discriminator arrangement comprises two similarly constructed frequency discriminators (53, 54) each having two inputs for the frequencies to be compared, in that the oscillator signal is applied to the first input of the frequency discriminators (53 and 54), in that the reference frequencies (f₁ and f₂) are applied to the second input of each time one of the two detectors, and in that the blocking circuit (57, 58) blocks the one frequency discriminator (53) when the oscillator frequency (fₒ) is above the first reference frequency (f₁) and blocks the other frequency discriminator (54) when the oscillator frequency is below the second reference frequency.

6. A circuit arrangement as claimed in any one of the preceding Claims,
characterised in that
the frequency discriminator circuit comprises at least one frequency-sensitive phase discriminator.

7. A circuit arrangement as claimed in any one of the preceding Claims,
characterised in that
the frequency discriminator arrangement comprises at least one frequency discriminator (35, 53, 54) each having an input for the frequency (fₒ) derived from the oscillator signal and for the reference frequency (f), in that the frequency discriminator supplies a current of a first polarity when the frequency at the one input is higher than that at the other input, and a current of a second polarity when the frequency at the one input is lower than that at the other input, and in that the output of the frequency discriminator is connected to a control input of the controllable oscillator via at least a diode (36, 57, 58).

8. A circuit arrangement as claimed in Claim 7,
characterised in that
an upper (f₁) and a lower (f₂) reference frequency is derived from a stabilized frequency (f_{N}) by means of a frequency divider (60) having a switchable frequency division factor, the lower reference frequency being lower than and the upper reference frequency being higher than the carrier frequency (fₒ).

9. A circuit arrangement as claimed in Claim 1, in which a control current for influencing the frequency is applied to the control input of the controllable oscillator and in which the phase discriminator has a high output resistance,
characterised in that
the output signal of the phase discriminator (27) and the frequency discriminator arrangement (35) is applied to the control input via an amplifier (38) having a high-impedance input and a low-impedance output.

10. A circuit arrangement as claimed in any one of the preceding Claims,
characterised by
its use in a radio receiver.

11. A circuit arrangement as claimed in Claim 9,
characterised by
its use in a stereo decoder.

## Revendications

1. Montage de circuit pour la synchronisation d'un oscillateur commandé en fréquence avec la fréquence d'une porteuse contenue dans un signal d'entrée, comportant un circuit PLL, dans lequel les phases du signal d'entrée et d'un signal issu de l'oscillateur commandé sont comparées dans un discriminateur de phase, dont le signal de sortie fonction de la différence de phase est acheminé via un filtre à une entrée de commande de l'oscillateur, étant entendu qu'est, en outre, prévu un circuit discriminateur de fréquence, qui produit un signal de commande fonction de la différence entre la fréquence de l'oscillateur (f₀) et une fréquence de référence (f) stable qui se situe à proximité de la fréquence porteuse, ce signal de commande étant acheminé également à l'entrée de commande de l'oscillateur et commandant celui-ci dans le sens d'une réduction de la différence entre la fréquence de référence et la fréquence de l'oscillateur, un circuit de blocage (57, 58) étant, en outre, prévu pour bloquer la commande par le circuit discriminateur de fréquence lorsque la fréquence de l'oscillateur (f₀) se situe au voisinage direct de la fréquence de référence (f) ou plus près de la fréquence porteuse que la fréquence de référence, caractérisé en ce que la fréquence à vide de l'oscillateur qui s'établit, sans application d'un signal de commande à l'entrée de commande de l'oscillateur comme fréquence d'oscillateur (f₀) est choisie de telle sorte qu'elle se situe, indépendamment des fluctuations des paramètres de fabrication et de fonctionnement dans un premier cas, au-dessus ou, dans un deuxième cas, en dessous de la fréquence porteuse, que la fréquence de référence (f) est choisie de telle sorte qu'elle se situe également, dans un premier cas, au-dessus ou, dans un deuxième cas, en dessous de la fréquence porteuse et entre la fréquence à vide et la fréquence porteuse, et le circuit de blocage (57, 58) bloque la commande de l'oscillateur par le circuit discriminateur de fréquence lorsque la fréquence (f₀) de l'oscillateur est devenu, dans un premier cas, plus faible ou, dans un deuxième cas, plus élevée que la fréquence de référence (f).

2. Montage de circuit selon la revendication 1, caractérisé en ce que la fréquence de référence est produite à l'aide d'un oscillateur de référence.

3. Montage de circuit selon la revendication 2, caractérisé en ce que la fréquence de l'oscillateur de référence est plus élevée que la fréquence porteuse et la fréquence de référence est issue de la fréquence de l'oscillateur de référence à l'aide d'au moins un diviseur de fréquence (31, 51, 53).

4. Montage de circuit selon la revendication 3, caractérisé en ce qu'il est prévu deux diviseurs de fréquence (51, 52) dont les facteurs de division de fréquence sont choisis tels que l'on obtienne une première fréquence de référence (f₁), qui se situe en dessous de la fréquence porteuse, et une deuxième fréquence de référence (f₂), qui se situe au-dessus de la fréquence porteuse, et le circuit de blocage (57, 58) est commuté de telle sorte que la commande de l'oscillateur commandé soit bloquée par le circuit discriminateur de fréquence (53, 54) lorsque la fréquence (f₀) se situe entre la première et la deuxième fréquences de référence (f₁, f₂).

5. Montage de circuit selon la revendication 4, caractérisé en ce que le circuit discriminateur de fréquence comporte deux discriminateurs de fréquence (53, 54) de même structure avec, respectivement, deux entrées pour les fréquences à comparer, le signal de l'oscillateur est acheminé à la première entrée des discriminateurs de fréquence (53 et 54), les fréquences de référence (f₁ et f₂) sont acheminées à la deuxième entrée, respectivement, d'un des deux détecteurs, et le circuit de blocage (57, 58) bloque le premier discriminateur de fréquence (53) lorsque la fréquence (f₀) de l'oscillateur se trouve au-dessus de la première fréquence de référence (f₁) et l'autre discriminateur de fréquence (54) lorsque la fréquence de l'oscillateur se situe en dessous de la deuxième fréquence de référence.

6. Montage de circuit selon l'une quelconque des revendications précédentes, caractérisé en ce que le circuit discriminateur de fréquence contient au moins un discriminateur de phase sensible à la fréquence.

7. Montage de circuit selon l'une quelconque des revendications précédentes, caractérisé en ce que le circuit discriminateur de fréquence comporte au moins un discriminateur de fréquence (35, 53, 54) avec, chaque fois, une entrée pour la fréquence (f0) issue du signal de l'oscillateur et pour la fréquence de référence (f), que le discriminateur de fréquence délivre un courant d'une première polarité lorsque la fréquence à la première entrée est supérieure à celle de l'autre entrée, et un courant d'une deuxième polarité lorsque la fréquence à la première entrée est plus petite que celle à l'autre entrée, et que la sortie du discriminateur de fréquence est connectée, via au moins une diode (36, 57, 58), à une entrée de commande de l'oscillateur commandé.

8. Montage de circuit selon la revendication 7, caractérisé en ce qu'une fréquence de référence supérieure (f₁) et une fréquence de référence inférieure (f₂) sont issues d'une fréquence stabilisée (f_{N}) à l'aide d'un diviseur de fréquence (60) ayant un facteur de division de fréquence commutable, la fréquence de référence inférieure étant plus petite et la fréquence de référence supérieure plus grande que la fréquence (f₀) de la porteuse.

9. Montage de circuit selon la revendication 1, dans lequel un courant de commande est acheminé à l'entrée de commande de l'oscillateur commandé pour influencer la fréquence et le discriminateur de phase présente une résistance de sortie élevée, caractérisé en ce que le signal de sortie du discriminateur de phase (27) et du circuit discriminateur de fréquence (35) est acheminé à l'entrée de commande via un amplificateur (38) à entrée à haute valeur ohmique et à sortie à basse valeur ohmique.

10. Montage de circuit selon l'une quelconque des revendications précédentes, caractérisé par son utilisation dans un récepteur radio.

11. Montage de circuit selon la revendication 9, caractérisé par son utilisation dans un décodeur stéréo.
